# EUROPEAN PATENT SPECIFICATION

(11) **EP 3 422 094 B1**
(45) Date of publication and mention of the grant of the patent: **15.09.2021**
(21) Application number: 18179150.0
(22) Date of filing: 21.06.2018
(51) Int. Cl.: G02F 1/1362, G02F 1/1345

(54) **ARRAY SUBSTRATE AND MOBILE TERMINAL**
ARRAY-SUBSTRAT UND MOBILES ENDGERÄT
SUBSTRAT DE RÉSEAU ET TERMINAL MOBILE

(30) Priority: 28.06.2017 CN 201710509551
(43) Date of publication of application: 02.01.2019
(73) Proprietor: Beijing Xiaomi Mobile Software Co., Ltd., Beijing 100085 (CN)
(72) Inventor: LIU, Ying, Beijing, Beijing 100085 (CN); LIU, Anyu, Beijing, Beijing 100085 (CN); LIU, Weiguang, Beijing, Beijing 100085 (CN)
(74) Representative: dompatent von Kreisler Selting Werner - Partnerschaft von Patent- und Rechtsanwälten mbB

(56) References cited:
- EP-A1- 3 232 431
- US-A1- 2016 111 040
- US-A1- 2017 115 542

## Description

### TECHNICAL FIELD

The present invention relates to the field of mobile terminal technology, and more particularly to an array substrate and a mobile terminal.

### BACKGROUND

With popularity of mobile terminals such as smart phones, more and more users tend to be interested in mobile terminals with a large screen and a narrow bezel. Since a mobile terminal has some accessory such as a front camera that occupies a certain part of its display screen, that part of the display screen that is occupied by the accessory cannot be used for display. In order to realize a narrow bezel, an array substrate in some related technologies has a notch, and a front camera is provided in the notch, so that both sides of the camera are able to display contents, and thus a ratio for display area can be increased and a narrow bezel can be achieved, as disclosed e.g. in US2016111040.

However, gate lines for pixel units on both sides of the notch occupy partial display area below the camera in order to avoid the notch, affecting visual appearance.

### SUMMARY

According to the present invention, there is provided an array substrate as defined in appended claim 1.

In some embodiments, the array substrate may further include: a third display area including display units that are below a bottom portion of the notch; and a plurality of third gate lines, each of which is shared by pixel units in a same row in the third display area, wherein the first gate drive circuit is connected electrically with the plurality of third gate lines for driving pixel units in the third display area.

In some embodiments, the first gate drive circuit may include a first drive unit and a second drive unit, wherein the first drive unit is connected electrically with the plurality of first gate lines for driving pixel units in the first display area, and the second drive unit is connected electrically with the plurality of third gate lines for driving pixel units in the third display area.

In some embodiments, the array substrate may include a first non-display area having a first drive unit, wherein the first non-display area is within a region between the notch and the first display area.

In some embodiments, the array substrate may further include at least two clock signal lines on at least one side of the display area.

In some embodiments, the at least two clock signal lines extend into the first non-display area; or the at least two clock signal lines extend into the second non-display area; or the at least two clock signal lines extend simultaneously into the first non-display area and the second non-display area.

In some embodiments, the array substrate may include a third non-display area having a first drive unit, wherein the third non-display area is within a region between the second display area and the base.

In some embodiments, the array substrate may include a fourth non-display area having a second drive unit, wherein the fourth non-display area is within a region between the second display area and the base.

According to a second aspect of the present invention, there is provided a mobile terminal including an array substrate according to any one of claims 1 to 9 and preset components provided in the notch.

In some embodiments, the preset components may include at least one of a camera, a receiver, a speaker and a light sensor.

The technical solution provided by the embodiments of the present invention may include the following beneficial effects:

As can be seen from the embodiments of the present invention, by providing a plurality of pixel units on a base with a notch to form a display area, wherein the same row pixel units at a first side of the notch sharing a first gate line, and the same row of pixel units at a second side of the notch sharing a second gate line, and by providing a first gate drive circuit for driving pixel units at the first side of the notch through a plurality of first gate lines and a second gate drive circuit for driving pixel units at the second side of the notch through a plurality of second gate lines, pixel units at different sides of the notch are driven by different gate drive circuits, and pixel units in a same row do not share a single gate line (that is, the embodiments of the present invention does not require the gate line to avoid the notch), depth of the notch can be reduced to enable design of a mobile terminal with a narrow bezel.

It is to be understood that both the foregoing general descriptions and the following detailed descriptions are exemplary and explanatory only and do not limit the scope of the disclosure.

### BRIEF DESCRIPTION OF THE DRAWINGS

The drawings herein are incorporated in and constitute a part of this specification, showing embodiments consistent with the present invention, and together with the descriptions, serve to explain the principles of the present invention.
Fig. 1 is a schematic structural view of an array substrate in the related arts;
Fig. 2 is a schematic structural view of an array substrate according to an example not forming part of the invention;
Fig. 3 is a schematic structural view of an array substrate according to an example not forming part of the invention;
Fig. 4 is a schematic structural view of an array substrate according to an example not forming part of the invention;
Fig.5 is a schematic structural view of an array substrate according to example not forming part of the invention;
Fig. 6 is a schematic structural view of an array substrate according to some exemplary embodiments; and
Fig. 7 is a schematic diagram of a structure of a mobile terminal according to some exemplary embodiments.

### DETAILED DESCRIPTION

Hereinafter, exemplary embodiments will be described in detail, examples of which are shown in the drawings. In the following descriptions when referring to the drawings, the same numerals in the different drawings denote the same or similar elements unless otherwise indicated. The embodiments described in the following exemplary embodiments are not representative of all embodiments consistent with the present invention. Rather, they are merely examples of devices and methods consistent with some aspects of the present invention as detailed in the appended claims.

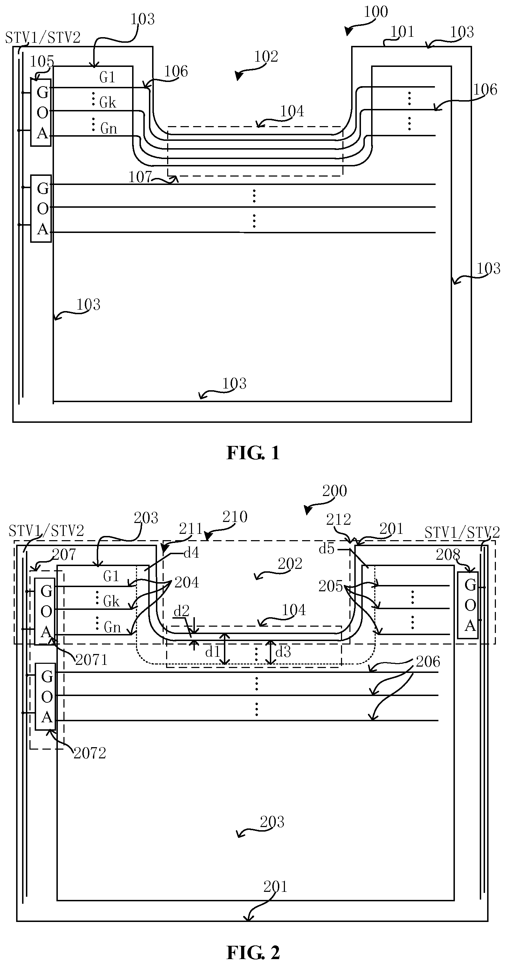

Fig.1 is a schematic structural view of an array substrate in the related art. As shown in Fig. 1, the array substrate 100 includes a base 101. A notch 102 is provided at an edge of the base 101. Some preset components can be provided in the notch 102. The preset components may be at least one of a camera, a receiver, a speaker, and a light sensor, for example. A plurality of pixel units (not shown) are provided on the base 101 to form a display area 103. The display region 103 has a shape that may vary with shape of the base 101 and the notch 102.

In order to ensure display of pixel units at both sides of the notch 102, as shown in Fig. 1, gate lines 106 are required to be designed for avoiding collision, i.e., the gate lines 106 extend through a hub region 104 from a first side of the notch 102 (the left side of the notch 102 in Fig.1) to a second side of the notch 102 (the right side of the notch 102 in Fig. 1). In this way, a gate drive circuit (Gate Driver On Array, GOA) 105 may drive pixel units on both sides of the notch 102 through the gate lines 106 (the gate lines 106 are respectively indicated by reference numerals G1, ..., Gk, ... Gn in Fig. 1). If the notch 102 has a deeper depth (the width in longitudinal direction in Fig. 1), there are a lot of rows of pixel units at both sides of the notch 102, and correspondingly, there is a bigger number of the gate lines 106, and the hub region 104 thus has a larger width, resulting in a narrower display area below a bottom portion of the notch 102. In other words, a region between opening of the notch 102 and an edge 107 of the hub region 104 away from the opening is not used for display, affecting visual appearance.

An example useful for understanding the present invention provides an array substrate. As shown in Fig. 2, the array substrate includes: a base 201; a notch 202 at an edge 210 of the base 201; a plurality of pixel units (not shown) on the base 201 to form a display area 203, wherein the display area 203 includes a first display area having pixel units of a first sub-edge 211 and a second display area having pixel units of a second sub-edge 212, and wherein the first sub-edge 211 is a region of the edge 210 at a first side (left side in Fig. 2) of the notch 202, and the second sub-edge 212 is a region of the edge 210 at a second side of the notch 202; a plurality of first gate lines 204, each of which is shared by pixel units in a same row in the first display area (the gate lines are respectively denoted in Fig. 2 by reference numerals G1, ..., Gk, ..., Gn); a plurality of second gate lines 205, each of which is shared by pixel units in a same row in the second display area; a first gate drive circuit 207 at the first side of the notch 202 and connected electrically with the plurality of first gate lines for driving pixel units in the first display area; and a second gate drive circuit 208 at the second side of the notch 202 and connected electrically with the plurality of second gate lines for driving pixel units in the second display area.

It is to be understood that the edge 210 is a region of the base 201 and corresponding to a portion of the base 201. Since the notch 210 is provided on this edge 210, it is assumed that the depth of the notch is the same as the width of the edge 210, i.e. the notch 202 divides the edge 210 into two parts, in order for convenience of understanding. The part of the edge 210 at the first side of the notch 202 is the first sub-edge 211 and the part of the edge 210 is at the second side of the notch 202 is the second sub-edge 212.

It should be noted that pixel units in a same row share a first gate line 204, which means that pixel units in one same row are controlled by drive signals from one same first gate line 204, and pixel units in multiple rows are respectively controlled by drive signals from multiple first gate lines 204. The arrangement of the gate lines and the pixel units may be designed by reference to related technologies and is not limited thereto.

The number of pixel units can be set according to actual requirements. For convenience of understanding, the plurality of pixel units in embodiments of the present invention may be arranged such that the pixel units are located in a row when seen from the row direction (left and right direction in Fig. 2) and the pixels units are located in a column when seen from the column direction (up and down direction in Fig. 2). It should be understood that if arrangement of the pixel units is changed, above-described structure of the array substrate may be adjusted accordingly without affecting effectiveness of embodiments of the present invention.

The pixel units at different sides of the notch 202 are driven by different gate drive circuits so that the pixel units in a same row but at different sides of the notch 202 do not share a gate line. That is, the gate lines in embodiments of the present invention do not need to avoid the notch 202. As shown in Fig. 2, the width of the hub region 104 is d1, while the width of the region becomes d2 when the solution of embodiments of the disclosure is applied. That is, the width of the hub region 104 is reduced by d3 (i.e., d1-d2). It can be seen that the depth of the notch can be reduced with utilization of the solution of embodiments of the present invention, which enables achievement of a mobile terminal with a narrow bezel.

The array substrate 200 may further includes a third display area having pixel units below a bottom portion of the notch 202; a plurality of third gate lines 206, each of which is shared by pixel units in a same row in the third display area, wherein the first gate drive circuit 207 is connected electrically with the plurality of third gate lines 206 for driving pixel units in the third display area. The first gate driving circuit 207 is electrically connected to the plurality of third gate lines 206 for driving the pixel units in the third display region.

In order to make the first display area and the third display area at different timings, the first gate drive circuit 207 in an embodiment of the present may include a first drive unit 2071 and a second drive unit 2072. The first drive unit 2071 is connected electrically with the plurality of first gate lines 204 for driving pixel units in the first display area. The second drive unit 2072 is connected electrically with the plurality of third gate lines 206 for driving pixel units in the third display area.

In some embodiments of the present disclosure, the first drive unit 2071 is provided in a region between the base 201 and the first display area, which does not occupy the display area, as shown in Fig. 2. Normally, since the second drive unit 2072 is also provided in this region, provision of the first drive unit 2071 will not increase width of the region. In the present embodiment, a distance between the first side of the notch 202 and an edge of the display area 203 can be reduced by d4 due to the fact that the first gate lines 204 does not need to avoid the notch 202 so that display area at the first side of the notch 202 can be increased, which enables achievement of a narrow bezel and improvement of visual esthetic sense.

In an example not forming part of the present disclosure, the second gate drive circuit 208 is provided in a region between the base 201 and the second display area, which does not occupy the display area, as shown in Fig. 2. It is to be understood that when the region is provided at an edge of a mobile terminal, width of the second gate drive circuit 208 (the left and right direction in Fig. 2) can be reduced while its length can be increased, which will further results in decrease of area of the bezel and increase of area of the display area. In the present embodiment, a distance between the second side of the notch 202 and the second display area can be reduced by d5 due to the fact that the second gate lines 205 does not need to avoid the notch 202 so that display area at the second side of the notch 202 can be increased (i.e. the second display area becomes larger), which enables achievement of a narrow bezel and improvement of visual esthetic sense.

In a specific use scenario, according to an embodiment of the present disclosure, the first drive unit 2071 and the second gate drive circuit 208 may be provided in accordance with the arrangement as shown in Fig. 2 so that the region occupied by the gate lines for avoiding the notch 102 shown in Fig. 1 may be eliminated. That is, edges of the display area and edges of the notch can be set as close as possible, and theoretically they can be coincident with each other. In practice, the bar area shown in Fig. 2 can be preset to facilitate welding of the preset components or the like.

In practical applications, it is necessary to control timing of the first drive unit 2071, the second gate drive circuit 208, and the second drive unit 2072 by clock signal lines. In a specific use scenario, at least two clock signal lines are required in the associated embodiment, and are provided on at least one side of the display area. In the example of the array substrate shown in Fig. 2, it is assumed that the clock signal lines STV1/STV2 are provided between edges of the display region 203 and edges of the base 201 and at the first side and/or the second side of the notch 202.

When providing the second gate drive circuit 208 on the array substrate, the clock signal line required for the second gate drive circuit 208 is provided in the area of the second gate drive circuit 208, i.e. the area between an edge of the display area 203 and an edge of the base 201 and at the second side of the notch 202. The clock signal lines STV1/STV2 at different sides of the notch 202 are provided by a same clock source to ensure that the gate drive circuits drive pixel units in a certain order. In Fig. 2, only the case where the array substrate has two clock signal lines is shown, it is to be understood that three, four, or even more clock signal lines may be set and their location may be at least one side of the display area.

It should be understood that when a clock signal line is provided only at the first side (or the second side) of the display area, it is necessary to extend the clock signal line to positions where the first drive unit and the second drive unit are located.

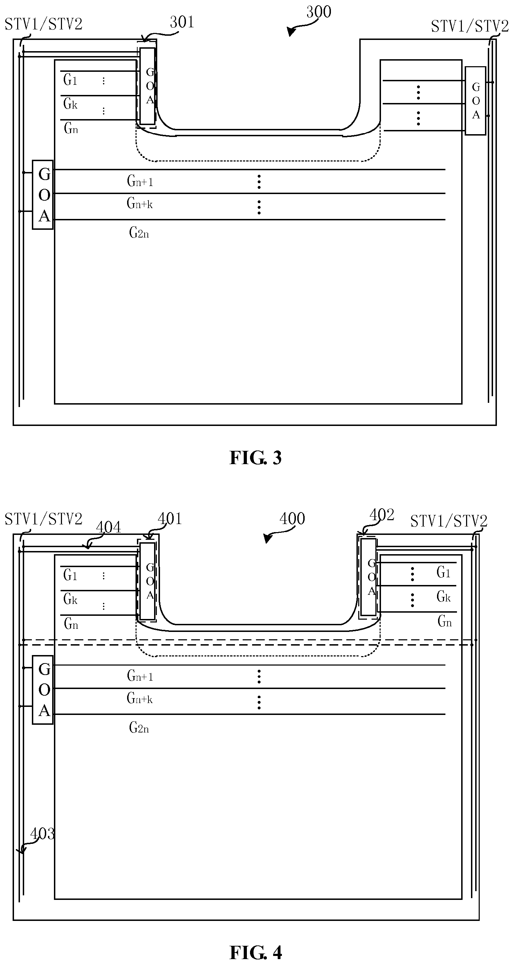

In an example not forming part of the present disclosure, as shown in Fig. 3, the array substrate 300 is provided with a first non-display area 301 which is between the first side of the notch 202 and the first display area. Correspondingly, the at least two clock signal lines extend to the first non-display area 301.

In an example not forming part of the present disclosure, as shown in Fig. 4, the array substrate 400 is provided with a second non-display area 402, which is between the second side of the notch 202 and the second display area. Correspondingly, the at least two clock signal lines extend to the second non-display area 402.

In an embodiment, the first non-display area and the second non-display area may be provided simultaneously, just as the first non-display area 401 and the second non-display area 402 shown in Fig. 4. Correspondingly, the at least two clock signal lines extend to both the first non-display area 401 and the second non-display area 402.

As shown in Fig. 4, for the clock signal line at the first side of the notch 202, it, when the first drive unit 2071 is provided in the first non-display area 401, may include a first line segment 403, a second line segment (not shown) and a first connection segment 404.

The first line segment 403 is located at the first side of the display area 203 for providing a clock signal to a gate drive circuit (e.g., the second drive unit 2072 in Fig. 2) connected to pixel units below a bottom portion of the notch 202. The first connection segment 404 is located at the first side of the notch 202 and is parallel to the gate lines for connecting the first line segment 403 and the second line segment. The second line segment is located in the first non-display area for providing a clock signal to the first drive unit 2071.

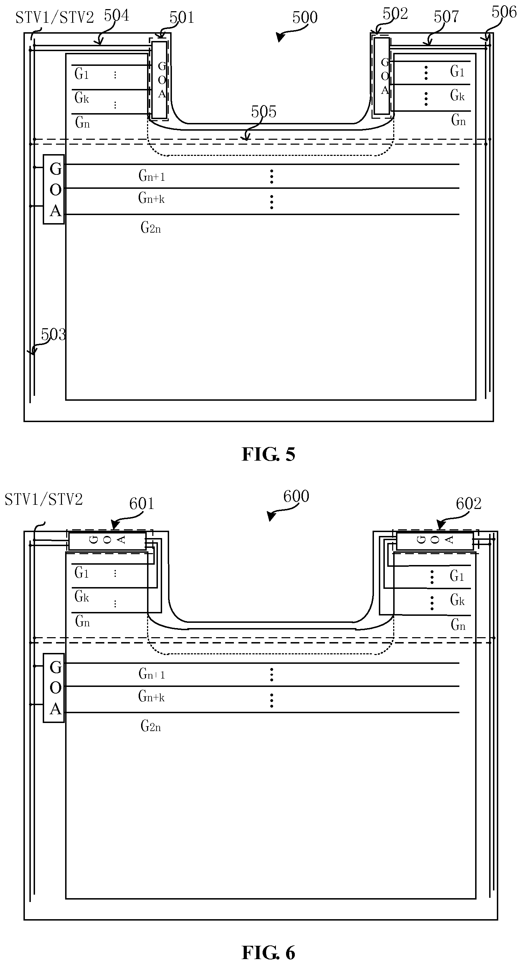

In an example not forming part of the present disclosure, as shown in Fig. 5, in the case where at least two clock signal lines are provided at the first side of the display area, the clock signal line includes a first line segment 503, a second line segment (not shown), a third line segment 506, a first connection segment 504, and a second connection segment 505.

The first line segment 503 is located at the first side of the display area (the left side of the display area in Fig. 5) for providing a clock signal to a gate drive circuit (e.g., the second drive unit 2072 in Fig.2) connected to pixel units below a bottom portion of the notch 202.

The first connection section is located at the first side of the notch 202 and is parallel to the gate lines for connecting the first line segment 503 and the second line segment.

The second line segment is located within the first non-display area 501 for providing a clock signal to the first drive unit 2071.

The second connection section 505 is located within the display area below a bottom portion of the notch and is parallel to the gate lines for connecting the first line segment 503 and the third line segment 506.

The third line segment 506 is located within the second non-display area 502 for providing a clock signal to the second gate drive circuit 208.

It is to be understood that the above-described second line segment is used to connect the first connection section 504 and the first drive unit 2071 located in the first non-display area 501, and it may be parallel to the first gate lines or perpendicular to the gate lines as required.

It is to understood that when the third line segment 506 supplies a clock signal to the second gate drive circuit 208, it is possible to provide the third connection section 507 and a fourth line segment according to location of the second gate drive circuit 208. The setting of the fourth line segment mat be the same as that for the second line segment, and will not be described in detail here.

It is to be understood that there is a delay in transmission of the clock signal line from the first side of the notch to the second side of the notch due to the width of the array substrate, so it is necessary to adjust drive timing of signals on the both sides to achieve simultaneous appearance of a same signal on both sides of the notch. The process of adjusting the clock signal can be made at the clock source and by reference to related technologies. The present disclosure is not limited thereto.

In an embodiment of the present disclosure, as shown in Fig. 6, the array substrate 600 is provided with a third non-display area 601 in which the first drive unit 2071 is provided for driving pixel units within the first display area (the left side of notch 20 in Fig. 6) through the first gate lines. The third non-display area 601 is within a region between the first display area and the base 201. When the first drive unit 2071 is provided in the third non-display area 601, the region occupied by the gate lines for avoiding the notch 102 in Fig. 1 can be eliminated so that the edge of the display area is as close as possible to the edge of the notch (the first display area becomes larger), which enables achievement of a narrow bezel and increase of the display area.

In some embodiments of the present disclosure, the array substrate 600 is provided with a fourth non-display area 602 in which the second gate drive circuit 208 is provided for driving pixel units in the second display area (the right side of the notch 202 in Fig. 6) through the second gate lines 205. The fourth non-display area 601 is within a region between the second display area and the base 201. When the second gate drive circuit 208 is provided in the fourth non-display area 602, the region occupied by the gate lines for avoiding the notch 102 in Fig. 1 can be eliminated so that the edge of the display area is as close as possible to the edge of the notch (the second display area becomes larger), which enables achievement of a narrow bezel and increase of the display area.

In an embodiment, the array substrate is provided with both the third non-display area 601 and the fourth non-display area 602 at the same time. In this way, the gate lines do not need to avoid the notch so that the edge of the display area is as close as possible to the edge of the notch (both the first and the second display area become larger), which enables achievement of a narrow bezel, increase of the display area and improvement of visual esthetical sense, and thereby attaining the beneficial effects as solution shown in Fig. 2.

It is to be understood that, in order to allow the first gate drive circuit and the second gate drive circuit to operate normally, an embodiment of the present disclosure adjusts, according to location of the first gate drive circuit and the second gate drive circuit, the clock signal lines such that that extend to the location of the first gate drive circuit and the second gate drive circuit to provide clock signals. The arrangement of the clock signal lines may be set by reference to those shown in Figs. 4 and 5 and will not be described in detail.

It is to be noted that, when the first gate drive circuit and the second gate drive circuit receive clock signals, gate drive signals are output to each pixel unit. Correspondingly, the data lines are input with pixel data. At this point, the pixel units display corresponding pixel values. Upon all rows of pixel units are displayed once a time in a preset order, a frame image is displayed. It is to be understood that dynamic display of an image can be achieved by adjusting frequency of the clock signals. The principle of image display can be known by reference to relevant technologies.

As such, in the array substrate provided by embodiments of the present disclosure, the pixel units on different sides of the notch are driven by different gate drive circuits so that the pixel units on a same row but at different sides of the notch do not share a gate line, i.e., the gate line does not need to avoid the notch. According to arrangement of the gate drive circuits, it is possible to reduce the width of the hub region , for example, the width of a region from bottom edge of the notch to the display area, the width of a region from the first side of the notch to the display area, and the width of a region from the second side of the notch to the display area, so as to enable achievement of a mobile terminal with a narrow frame bezel.

The present disclosure also provides a mobile terminal in some embodiments. The mobile terminal includes an array substrate and preset components provided in the notch. The preset components may be at least one of a camera, a receiver, a speaker and a light sensor, for example.

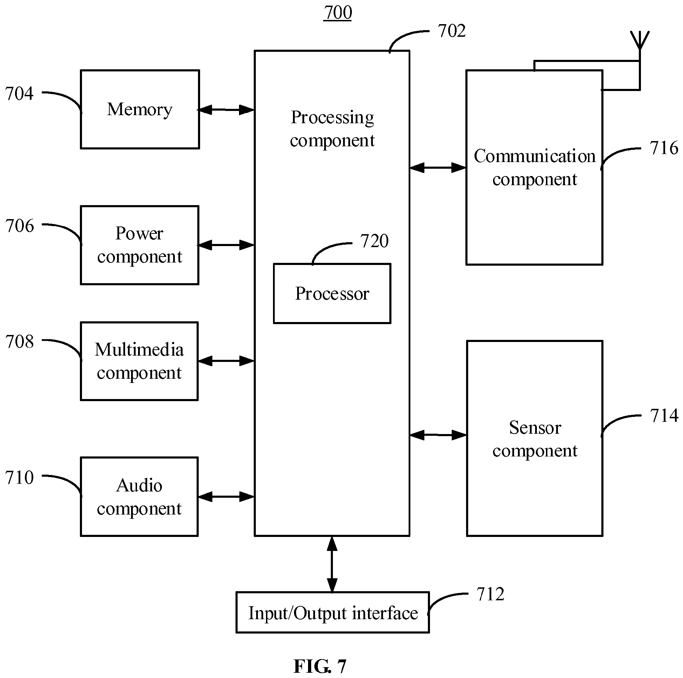

As shown in Fig. 7, the mobile terminal 700 may be a mobile phone, a computer, a digital broadcast terminal, a messaging device, a gaming console, a tablet, a medical device, an exercise equipment, a personal digital assistant, and the like.

By reference to Fig. 7, the mobile terminal 700 may include one or more of the following components: a processing component 702, a memory 704, a power component 706, a multimedia component 708, an audio component 710, an input/output (I/O) interface 712, a sensor component 714, and a communication component 716.

The processing component 702 typically controls overall operations of the mobile terminal 700, such as the operations associated with display, telephone calls, data communications, camera operations, and recording operations. The processing component 702 may include one or more processors 720 to execute instructions. Moreover, the processing component 702 may include one or more modules which facilitate the interaction between the processing component 702 and other components. For instance, the processing component 702 may include a multimedia module to facilitate the interaction between the multimedia component 708 and the processing component 702.

The memory 704 is configured to store various types of data to support the operation of the mobile terminal 700. Examples of such data include instructions for any applications or methods operated on the mobile terminal 700, contact data, phonebook data, messages, pictures, video, etc. The memory 704 may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The power component 706 provides power to various components of the mobile terminal 700. The power component 706 may include a power management system, one or more power sources, and any other components associated with the generation, management, and distribution of power in the mobile terminal 700.

The multimedia component 708 includes a screen providing an output interface between the mobile terminal 700 and the user. In some embodiments, the screen may include a liquid crystal display (LCD) and a touch panel (TP). If the screen includes the touch panel, the screen may be implemented as a touch screen to receive input signals from the user. The touch panel includes one or more touch sensors to sense touches, swipes, and gestures on the touch panel. The touch sensors may not only sense a boundary of a touch or swiping action, but also sense a period of time and a pressure associated with the touch or swiping action. In some embodiments, the multimedia component 708 includes a front camera and/or a rear camera. The front camera and the rear camera may receive an external multimedia datum while the mobile terminal 700 is in an operation mode, such as a photographing mode or a video mode. Each of the front camera and the rear camera may be a fixed optical lens system or have focus and optical zoom capability.

The audio component 710 is configured to output and/or input audio signals. For example, the audio component 710 includes a microphone ("MIC") configured to receive an external audio signal when the mobile terminal 700 is in an operation mode, such as a call mode, a recording mode, and a voice recognition mode. The received audio signal may be further stored in the memory 704 or transmitted via the communication component 716. In some embodiments, the audio component 710 further includes a speaker to output audio signals.

The I/O interface 712 provides an interface between the processing component 702 and peripheral interface modules, such as a keyboard, a click wheel, buttons, and the like. The buttons may include, but are not limited to, a home button, a volume button, a starting button, and a locking button.

The sensor component 714 includes one or more sensors to provide status assessments of various aspects of the mobile terminal 700. For instance, the sensor component 714 may detect an open/closed status of the mobile terminal 700, relative positioning of components, e.g., the display and the keypad, of the mobile terminal 700. The sensor component 714 may further detect a change in position of the mobile terminal 700 or a component of the mobile terminal 700, a presence or absence of user contact with the mobile terminal 700, an orientation or an acceleration/deceleration of the mobile terminal 700, and a change in temperature of the mobile terminal 700. The sensor component 714 may include a proximity sensor configured to detect the presence of nearby objects without any physical contact. The sensor component 714 may also include a light sensor, such as a CMOS or CCD image sensor, for use in imaging applications. In some embodiments, the sensor component 714 may also include an accelerometer sensor, a gyroscope sensor, a magnetic sensor, a pressure sensor, or a temperature sensor.

The communication component 716 is configured to facilitate communication, wired or wirelessly, between the mobile terminal 700 and other devices. The mobile terminal 700 can access a wireless network based on a communication standard, such as WiFi, 2G, or 3G, or a combination thereof. In one exemplary embodiment, the communication component 716 receives a broadcast signal or broadcast associated information from an external broadcast management system via a broadcast channel. In one exemplary embodiment, the communication component 716 further includes a near field communication (NFC) module to facilitate short-range communications. For example, the NFC module may be implemented based on a radio frequency identification (RFID) technology, an infrared data association (IrDA) technology, an ultra-wideband (UWB) technology, a Bluetooth (BT) technology, and other technologies.

In exemplary embodiments, the mobile terminal 700 may be implemented with one or more application specific integrated circuits (ASICs), digital signal processors (DSPs), digital signal processing devices (DSPDs), programmable logic devices (PLDs), field programmable gate arrays (FPGAs), controllers, micro-controllers, microprocessors, or other electronic components.

In exemplary embodiments, there is also provided a non-transitory computer-readable storage medium including instructions, such as included in the memory 704, executable by the processor 720 in the mobile terminal 700. For example, the non-transitory computer-readable storage medium may be a ROM, a RAM, a CD-ROM, a magnetic tape, a floppy disc, an optical data storage device, and the like.

A person skilled in the art, when considering the descriptions and practicing the present disclosure, will easily conceive other implementations of the present disclosure. The present application is intended to cover any variation, use or adaptation of the disclosure, which follow general principle of the disclosure and include general knowledge or customary technical means in the related art that are not discussed herein as long as they fall within the scope of the claims. The descriptions and embodiments are only regarded to be exemplary, and real scope of the disclosure are indicated by the following claims.

It should be understood that the present disclosure is not limited to the precise structure described above and shown in the drawings, and can be modified and changed without going beyond its scope which is limited only by the appended claims.

## Claims

1. An array substrate (200), comprising:
a base (201);
a notch (202) at an edge region (210) of the base (201);
a plurality of pixel units on the base (201) to form a display area (203), wherein the display area comprises a first display area including pixel units within a first sub-edge region (211) and a second display area including pixel units within a second sub-edge region (212), and wherein the first sub-edge region (211) forms a part of the edge region (210) at a first side of the notch (202), and the second sub-edge region (212) forms a part of the edge region (210) at a second side of the notch (202);
a plurality of first gate lines (204), each of which is shared by pixel units in a same row in the first display area;
a plurality of second gate lines (205), each of which is shared by pixel units in a same row in the second display area;
a first gate drive circuit (207) at the first side of the notch (202) and connected electrically with all of the plurality of first gate lines (204) for driving pixel units in the first display area through respective ones of the plurality of the first gate lines; and
a second gate drive circuit (208) at the second side of the notch (202) and connected electrically with all of the plurality of second gate lines (205) for driving pixel units in the second display area through respective ones of the plurality of the second gate lines,
**characterised in that**
the second gate drive circuit is located within a region between the second display area and a border of the base (201) above the second display area, and the plurality of second gate lines (205) are located within a region between the second display area and the notch (202).

2. The array substrate according to claim 1, wherein the array substrate (200) further comprises:
a third display area comprising pixel units that are below a side of the notch that is opposite to an opening side of the notch; and
a plurality of third gate lines (206), each of which is shared by pixel units in a same row in the third display area,
wherein the first gate drive circuit (207) is connected electrically with all of the plurality of third gate lines for driving pixel units in the third display area.

3. The array substrate according to claim 1 or claim 2, wherein the first gate drive circuit (207) comprises a first drive unit (2071) and a second drive unit (2072),
wherein the first drive unit (2071) is connected electrically with all of the plurality of first gate lines (204) for driving pixel units in the first display area, and
wherein the second drive unit (2072) is connected electrically with all of the plurality of third gate lines (206) for driving pixel units in the third display area.

4. The array substrate according to any of claims 1 to 3, wherein the array substrate (200) comprises a first non-display area (301) having the first gate drive circuit (207),
wherein the first non-display area (301) is within a region between the notch (202) and the first display area.

5. The array substrate according to claim 4, wherein the array substrate (200) further comprises at least two clock signal lines on at least one side of the display area.

6. The array substrate according to claim 5, wherein
the at least two clock signal lines extend into the first non-display area (301).

7. The array substrate according to any of claims 1 to 3, wherein the array substrate (200) comprises a third non-display area (601) having the first gate drive circuit (207),
wherein the third non-display area (601) is within a region between the first display area and a border of the base (201) above the first display area.

8. A mobile terminal (700), comprising an array substrate (200) according to any one of claims 1 to 7 and preset components provided in the notch (202).

9. The mobile terminal according to claim 8, wherein the preset components comprise at least one of a camera, a receiver, a speaker, a light sensor, a proximity sensor and a microphone.

## Patentansprüche

1. Array-Substrat (200) mit:
einer Basis (201);
einer Kerbe (202) an einem Randbereich (210) der Basis (201);
mehreren Pixeleinheiten auf der Basis (201) zur Bildung eines Displaybereichs, wobei der Displaybereich einen ersten Displaybereich mit Pixeleinheiten innerhalb eines ersten Teil-Randbereichs (211) und einen zweiten Anzeigebereich mit Pixeleinheiten innerhalb eines zweiten Teil-Randbereichs (212) aufweist, und wobei der erste Teil-Randbereich (211) einen Teil des Randbereichs (210) auf einer ersten Seite der Kerbe (202) bildet, und der zweite Teil-Randbereich (212) einen Teil des Randbereichs (210) auf einer zweiten Seite der Kerbe (202) bildet;
mehreren ersten Gate-Leitungen (204), welche sich Pixeleinheiten in derselben Reihe in dem ersten Displaybereich teilen;
mehreren zweiten Gate-Leitungen (205), welche sich Pixeleinheiten in derselben Reihe in dem zweiten Displaybereich teilen;
einer ersten Gate-Ansteuerschaltung (207), die auf der ersten Seite der Kerbe (202) angeordnet sind und mit sämtlichen der mehreren ersten Gate-Leitungen (204) elektrisch verbunden sind, um Pixeleinheiten in dem ersten Displaybereich durch jeweilige der mehreren ersten Gate-Leitungen anzusteuern; und
einer zweiten Gate-Ansteuerschaltung (208), die auf der zweiten Seite der Kerbe (202) angeordnet sind und mit sämtlichen der mehreren zweiten Gate-Leitungen (205) elektrisch verbunden sind, um Pixeleinheiten in dem zweiten Displaybereich durch jeweilige der mehreren zweiten Gate-Leitungen anzusteuern,
**dadurch gekennzeichnet, dass**
die zweite Gate-Ansteuereinheit in einem Bereich zwischen dem zweiten Displaybereich und einer Grenze der Basis (201) über dem zweiten Displaybereich angeordnet ist, und die mehreren zweiten Gate-Leitungen (205) in einem Bereich zwischen dem zweiten Displaybereich und der Kerbe (202) angeordnet sind.

2. Array-Substrat nach Anspruch 1, bei welchem das Array-Substrat (200) ferner aufweist:
einen dritten Displaybereich mit Pixeleinheiten, die sich unter einer Seite der Kerbe befinden, die einer Öffnungsseite der Kerbe entgegengesetzt ist; und
mehrere dritte Gate-Leitungen (206), welche sich Pixeleinheiten in derselben Reihe in dem dritten Displaybereich teilen,
wobei die erste Gate-Ansteuerschaltung (207) elektrisch mit sämtlichen der mehreren dritten Gate-Leitungen verbunden ist, um Pixeleinheiten in dem dritten Displaybereich anzusteuern.

3. Array-Substrat nach Anspruch 1 oder Anspruch 2, bei welchem die erste Gate-Ansteuerschaltung (207) eine erste Ansteuereinheit (2071) und eine zweite Ansteuereinheit (2072) aufweist,
wobei die erste Ansteuereinheit (2071) elektrisch mit sämtlichen der mehreren ersten Gate-Leitungen (204) verbunden ist, um Pixeleinheiten in dem ersten Displaybereich anzusteuern, und
wobei die erste Ansteuereinheit (2072) elektrisch mit sämtlichen der mehreren zweiten Gate-Leitungen (205) verbunden ist, um Pixeleinheiten in dem zweiten Displaybereich anzusteuern.

4. Array-Substrat nach einem der Ansprüche 1 bis 3, bei welchem das Array-Substrat (200) einen ersten Nicht-Displaybereich (301) mit der ersten Gate-Ansteuerschaltung (207) aufweist,
wobei der erste Nicht-Displaybereich (301) innerhalb eines Bereichs zwischen der Kerbe (202) und dem ersten Anzeigebereich angeordnet ist.

5. Array-Substrat nach Anspruch 4, bei welchem das Array-Substrat (200) ferner mindestens zwei Taktsignalleitungen auf mindestens einer Seite des Displaybereichs aufweist.

6. Array-Substrat nach Anspruch 5, bei welchem die mindestens zwei Taktsignalleitungen sich in den ersten Nicht-Displaybereich (301) erstrecken.

7. Array-Substrat nach einem der Ansprüche 1 bis 3, bei welchem das Array-Substrat (200) einen dritten Nicht-Displaybereich (601) mit der ersten Gate-Ansteuerschaltung (207) aufweist,
wobei der dritte Nicht-Displaybereich (601) innerhalb eines Bereichs zwischen ersten Anzeigebereich und einer Grenze der Basis (201) über dem ersten Displaybereich angeordnet ist.

8. Mobiles Endgerät (700) mit einem Array-Substrat (200) nach einem der Ansprüche 1 bis 7 und in der Kerbe (202) vorgesehenen vorbestimmten Komponenten.

9. Mobiles Endgerät nach Anspruch 8, bei welchem die vorbestimmten Komponenten eine Kamera und/oder einen Empfänger und/oder einen Lautsprecher und/odereinen Lichtsensor und/oder einen Näherungssensor und/oder ein Mikrophon aufweisen.

## Revendications

1. Substrat de réseau (200), comprenant :
une base (201) ;
une encoche (202) au niveau d'une région de bord (210) de la base (201) ;
une pluralité d'unités de pixels sur la base (201) pour former une zone d'affichage (203), la zone d'affichage comprenant une première zone d'affichage comportant des unités de pixels à l'intérieur d'une première région de sous-bord (211) et une deuxième zone d'affichage comportant des unités de pixels à l'intérieur d'une seconde région de sous-bord (212), et la première région de sous-bord (211) formant une partie de la région de bord (210) sur un premier côté de l'encoche (202), et de la seconde région de sous-bord (212) formant une partie de la région de bord (210) sur un second côté de l'encoche (202) ;
une pluralité de premières lignes de porte (204), dont chacune est partagée par des unités de pixels dans une même ligne dans la première zone d'affichage ;
une pluralité de secondes lignes de porte (205), dont chacune est partagée par des unités de pixels dans une même ligne dans la deuxième zone d'affichage ;
un premier circuit d'attaque de porte (207) au niveau du premier côté de l'encoche (202) et connecté électriquement à toutes de la pluralité de premières lignes de porte (204) pour attaquer des unités de pixels dans la première zone d'affichage à travers celles respectives de la pluralité des premières lignes de porte ; et
un second circuit d'attaque de porte (208) sur le second côté de l'encoche (202) et connecté électriquement à toutes les secondes lignes de porte (205) pour attaquer des unités de pixels dans la seconde zone d'affichage à travers celles respectives de la pluralité des deuxièmes lignes de porte,
**caractérisé en ce que**
le second circuit d'attaque de porte est situé dans une région entre la deuxième zone d'affichage et une bordure de la base (201) au-dessus de la deuxième zone d'affichage, et la pluralité de deuxièmes lignes de porte (205) sont situées à l'intérieur d'une région entre la deuxième zone d'affichage et l'encoche (202).

2. Substrat de réseau selon la revendication 1, le substrat de réseau (200) comprenant en outre :
une troisième zone d'affichage comprenant des unités de pixels qui sont en dessous d'un côté de l'encoche qui est opposé à un côté d'ouverture de l'encoche ; et
une pluralité de troisièmes lignes de porte (206), dont chacune est partagée par des unités de pixels dans une même ligne dans la troisième zone d'affichage,
le premier circuit d'attaque de porte (207) étant connecté électriquement à toutes la pluralité de troisièmes lignes de porte pour attaquer des unités de pixels dans la troisième zone d'affichage.

3. Substrat de réseau selon la revendication 1 ou la revendication 2, le premier circuit d'attaque de porte (207) comprenant une première unité d'attaque (2071) et une seconde unité d'attaque (2072),
la première unité d'entraînement (2071) étant connectée électriquement à toutes la pluralité de premières lignes de porte (204) pour attaquer des unités de pixels dans la première zone d'affichage, et
la seconde unité d'attaque (2072) étant connectée électriquement à toutes la pluralité de troisièmes lignes de porte (206) pour attaquer des unités de pixels dans la troisième zone d'affichage.

4. Substrat de réseau selon l'une quelconque des revendications 1 à 3, le substrat de réseau (200) comprenant une première zone de non-affichage (301) ayant le premier circuit d'attaque de porte (207),
la première zone de non-affichage (301) étant à l'intérieur d'une région entre l'encoche (202) et la première zone d'affichage.

5. Substrat de réseau selon la revendication 4, le substrat de réseau (200) comprenant en outre au moins deux lignes de signal d'horloge sur au moins un côté de la zone d'affichage.

6. Substrat de réseau selon la revendication 5,
les au moins deux lignes de signal d'horloge s'étendant dans la première zone de non-affichage (301).

7. Substrat de réseau selon l'une quelconque des revendications 1 à 3, le substrat de réseau (200) comprenant une troisième zone de non-affichage (601) ayant le premier circuit d'attaque de porte (207),
la troisième zone de non-affichage (601) étant à l'intérieur d'une région entre la première zone d'affichage et une bordure de la base (201) au-dessus de la première zone d'affichage.

8. Terminal mobile (700), comprenant un substrat de réseau (200) selon l'une quelconque des revendications 1 à 7 et des composants prédéfinis prévus dans l'encoche (202).

9. Terminal mobile selon la revendication 8, les composants prédéfinis comprenant une caméra, et/ou un récepteur, et/ou un haut-parleur, et/ou un capteur de lumière, et/ou un capteur de proximité et/ou un microphone.
